# FASCICULE DE BREVET EUROPEEN

(11) **EP 3 278 274 B1**
(45) Date de publication et mention de la délivrance du brevet: **05.06.2019**
(21) Numéro de dépôt: 16729298.6
(22) Date de dépôt: 01.04.2016
(51) Int. Cl.: G06K 19/077, H01L 23/48

(54) **MODULE DUAL POUR CARTE DUALE À MICROCIRCUIT**
DOPPELMODUL FÜR DOPPELCHIPKARTE
DUAL MODULE FOR DUAL CHIP CARD

(30) Priorité: 02.04.2015 FR 1552865
(43) Date de publication de la demande: 07.02.2018
(73) Titulaire: IDEMIA France, 92400 Courbevoie (FR)
(72) Inventeur: GAC, Philippe, 92700 Colombes (FR); HUET, Mickaël, 92700 Colombes (FR); FONTAINE, Jean-Michel, 92700 Colombes (FR)
(74) Mandataire: Santarelli
(86) Numéro de dépôt international: PCT/FR2016/050744
(87) Numéro de publication internationale: WO 2016/156755

(56) Documents cités:
- FR-A1- 2 769 390
- FR-A1- 2 861 201

## Description

L'invention concerne la miniaturisation des modules à microcircuit que comportent des cartes à microcircuit de type dual, c'est-à-dire des cartes à microcircuit capables de communiquer avec l'extérieur à la fois avec une interface physique au moyen de plages de contact et avec une interface sans contact au moyen d'une antenne.

Depuis le format des cartes de crédit, ou des cartes d'identité, divers formats plus petits ont été définis, et normalisés pour satisfaire divers types de besoins. Le format des cartes de crédit ayant été appelé « ID-1 » ou « 1FF », on a défini le format ID-000 ou 2FF qui s'applique aux cartes d'identification d'abonnés à des services de téléphonie (cartes SIM), puis le format 3FF aussi appelé « mini-SIM ». Plus récemment on a défini le format 4FF ou « nano-SIM ».

De telles cartes comportent un corps dont une cavité contient un module à microcircuit formé d'un film support comportant, sur une face dite face externe, un ensemble de plages de contact destinées à venir en contact avec des plages de contact d'un terminal de communication par contact et, sur l'autre face dite face interne, un microcircuit dont des bornes sont connectées aux plages de contact au travers du film-support. La fixation du module au corps peut se faire à la fois entre le film-support et le bord de la cavité et/ou entre une masse de résine englobant le microcircuit et le fond de la cavité.

On comprend que, pour satisfaire aux conditions fixées par les normes applicables aux cartes à microcircuit, notamment les normes ISO - 14443 et ISO - 7816, les modules doivent satisfaire à un certain nombre de conditions, notamment en ce qui concerne les dimensions et la disposition des plages de contact.

L'antenne que comporte une carte à microcircuit du type dual est habituellement formée dans le corps qui contient le module, en ayant des extrémités situées à proximité de la cavité contenant ce module ; cette antenne est accordée à la même fréquence que les terminaux avec lesquels elle est destinée à pouvoir communiquer, en pratique à 13.56 MHz ; pour pouvoir être intégré à une carte à microcircuit du type dual, un module doit donc être conformé en sorte de pouvoir connecter son microcircuit aux extrémités de l'antenne ; cette connexion est habituellement réalisée par l'intermédiaire de plages internes de contact, c'est-à-dire par l'intermédiaire de plages situées sur la face interne du film-support, opposée à la face portant les plages de contact destinées à être mises en contact avec un terminal de communication par contact ; un tel module est lui aussi qualifié de module de type dual.

Tant que les dimensions des cartes étaient sensiblement supérieures aux dimensions des modules, un même format de module a pu être utilisé, par fois appelé format M4 ayant une longueur de 13 mm et une largeur de 11.8 mm (les dimensions du format 1FF sont de 85.60 mm x 53.98 mm, celles du format 2FF sont de 25 mm x 15 mm, et celles du format 3FF sont de 15 mm x 12 mm). Pour les cartes les plus grandes on a même défini un format de module plus grand, appelé M5. Afin de réduire les coûts de production, il est apparu souhaitable de disposer d'un module de format plus petit ; c'est ainsi qu'a été proposé un format M3 dont les dimensions sont de l'ordre de 11 +/-0.2 mm x 82 +/-0.2 mm (par exemple 10,85mm*8,17mm ; ce format n'est pas complètement stabilisé).

La durée de vie d'une carte à microcircuit dépend de manière importante de la capacité de son module à résister aux diverses sollicitations mécaniques voire thermiques qu'un utilisateur peut être amené à lui faire subir, ne serait-ce que pour la faire entrer dans le logement d'un porte-carte ou à l'en faire sortir ; en outre, la nature souvent confidentielle des données contenues dans le microcircuit impose que le microcircuit ne puisse être détaché de la carte qui le contient sans être détruit. Cela a conduit à la définition d'un grand nombre de tests (notamment en torsion) qu'un module doit être capable de subir sans dégradation, ou doit au contraire ne pas pouvoir subir sans destruction irrémédiable du microcircuit. En d'autres termes, un module doit, dans certaines zones, être flexible et, dans d'autres zones, être aussi rigide que possible.

La face externe d'un module, c'est-à-dire la face comportant les plages de contact est en pratique presque entièrement métallisée de manière à ce que chacune des plages de contact ait une superficie suffisante pour satisfaire aux normes applicables aux cartes ; par contre, cette face ne peut pas être entièrement métallisée puisque les diverses plages de contact doivent être suffisamment isolées électriquement les unes vis-à-vis des autres pour permettre une utilisation satisfaisante de chacune d'entre elles.

Ces plages de contact sont électriquement conductrices, habituellement formées de cuivre.

La connexion du microcircuit avec les plages externes de contact ou les plages de connexion à l'antenne peut être réalisée au moyen de fils de connexion, typiquement des fils d'or. Selon une autre option, la face interne du film-support comporte un circuit imprimé qui comporte des zones auxquelles se connectent directement les bornes du microcircuit ; on comprend toutefois que le mode de connexion par fil accorde une plus grande souplesse puisqu'il permet de s'adapter à plusieurs géométries de microcircuit (ce qui n'est pas le cas du mode de connexion par circuit imprimé qui dépend de la géométrie des bornes du microcircuit).

Le document FR2861201 A1 divulgue un module dual (20) pour carte duale (figure 3) à microcircuit, comportant un film-support (21) portant sur une face dite externe une pluralité de plages de contact électrique (22) comportant deux séries de plages de contact électrique s'étendant selon une direction donnée en longeant sur toute leur longueur deux bords de ce film-support qui sont parallèles à cette direction et, sur une face dite interne deux zones internes de connexion (24, 25) destinées à être connectées à une antenne de ladite carte duale à microcircuit et un microcircuit (23), ce microcircuit comportant des bornes de connexion connectées par des fils respectivement aux zones internes de connexion ou à certaines des plages de contact électrique par l'intermédiaire de vias traversant ce film-support tout en étant enrobé, conjointement avec ces fils, par une masse de résine d'enrobage (40).

L'invention a pour objet un module du type dual, comportant donc des plages de contact sur une face externe et des plages de connexion à une antenne sur une face interne, de petit format mais respectant les conditions de performances mécaniques s'appliquant notamment au format M4, notamment en flexion/torsion, sans pour autant réduire les tolérances dimensionnelles dans les opérations d'encartage, tout en impliquant un coût modéré, notamment du fait que le film-support est configuré en sorte de pouvoir être associé à une grande variété de géométries de microcircuits.

Il est à noter que le besoin de disposer de petits modules n'est pas nécessairement lié à la taille de la carte dans laquelle on prévoit d'implanter de tels modules ; ainsi, il peut être intéressant de pouvoir implanter de petits modules dans des cartes de formats supérieurs à 2FF, y compris au format ID-1, lorsque l'on souhaite pouvoir implanter de grandes antennes, ou lorsque, notamment, diverses étapes de sécurisation doivent être appliquées sur la surface du corps de carte (par exemple implantation de manière non modifiable d'un signe ou d'une photo).

L'invention propose à cet effet un module dual pour carte duale à microcircuit, comportant un film-support portant sur une face dite externe une pluralité de plages de contact électrique (C1-C8) comportant deux séries de plages de contact électrique s'étendant selon une direction donnée en longeant sur toute leur longueur deux bords de ce film-support qui sont parallèles à cette direction et, sur une face dite interne deux zones internes de connexion destinées à être connectées à une antenne de ladite carte duale à microcircuit et un microcircuit, ce microcircuit comportant des bornes de connexion connectées par des fils respectivement aux zones internes de connexion ou à certaines des plages de contact électrique par l'intermédiaire de vias traversant ce film-support tout en étant enrobé, conjointement avec ces fils, par une masse de résine d'enrobage, caractérisé en ce que les séries de plages de contact électrique de la face externe comportent trois plages seulement (C1-C3, C5-C7) et en ce que chacune des deux zones internes de connexion est conformée en un peigne comportant un corps s'étendant sous chacune des plages de l'une respective des deux séries de plage de contact à distance de la masse d'enrobage, et des dents, dont deux dents extrêmes partant des extrémités du corps et, de préférence, au moins une dent intermédiaire, qui s'étendent indépendamment les unes des autres à partir dudit corps transversalement à la direction donnée jusqu'à des extrémités couvertes par la masse d'enrobage, l'une des extrémités d'une dent de chaque peigne étant connectée par un desdits fils à une desdites bornes de connexion du microcircuit.

On appréciera qu'un tel module permet de combiner une masse de résine d'enrobage importante avec une grande liberté dans le choix des zones de la face interne auxquelles aboutissent les fils de connexion (en fonction de la géométrie particulière du microcircuit choisi pour faire partie du module, sans compliquer les modalités d'encartage d'un tel module dans le corps de carte d'une carte duale malgré l'obligation de connecter des zones internes de connexion aux extrémités de l'antenne de ce corps.
De manière avantageuse les dents des peignes s'étendent à partir de leur corps de part et d'autre des vias, les dents extrêmes de chaque peigne, qui sont les plus éloignées l'une de l'autre, étant plus longues que les autres dents du même peigne de sorte que leurs extrémités sont en regard d'une zone de la face externe qui est située entre lesdites séries de plages de contact électrique. Ainsi, les extrémités de l'ensemble des dents forment une zone polygonale dont deux bords, au moins approximativement perpendiculairement à la direction des séries des plages de contact, ont une longueur inférieure à la distance séparant les deux séries de plages de contact ; cela permet de positionner les extrémités des dents extrêmes entre les plages de contact, et ainsi réduire la surface recouverte par la masse d'enrobage tout en permettant une réduction de la longueur des fils de connexion.

De manière particulièrement avantageuse les vias sont reliés, sur la face interne du film-support, à des pistes métallisées parallèles et/ou perpendiculaires à la direction des séries de plages, passant entre les extrémités, en regard, des dents extrêmes de deux peignes distincts, en des zones médianes sensiblement situées à mi-distance des bords du film-support qui sont longées par les séries de plages de contact électrique. Ainsi, ces pistes contribuent, avec les extrémités et les vias, à délimiter la zone centrale entourant le microcircuit tout en permettant aux extrémités d'encadrer cette zone centrale perpendiculairement à la direction des séries de plages de contact. Ces pistes sont avantageusement formées de brins parallèles, ou perpendiculaires, à cette direction.

Selon une autre caractéristique avantageuse de l'invention, les pistes métallisées reliées aux vias ont, à l'extérieur de la masse de résine enrobant le microcircuit et les fils de connexion, une forme courbe ; cela contribue à la tenue mécanique du module.

Selon encore une autre caractéristique avantageuse de l'invention, les extrémités des dents des deux peignes délimitent conjointement une zone centrale polygonale entourant le microcircuit, à l'extérieur de laquelle sont situés les vias, ce qui contribue à la réduction de la masse d'enrobage nécessaire pour recouvrir les vias et les extrémités des dents des deux peignes dans la direction donnée. Il en résulte une plus grande largeur disponible dans la direction donnée pour l'adhésif et ainsi assurer une bonne adhésion du microcircuit au film-support et de la masse d'enrobage à ce film-support.

Selon une autre caractéristique avantageuse de l'invention, les dents extrêmes ont des extrémités présentant des décrochements vers la zone centrale, ce qui contribue à réduire la surface du film-support qui doit être recouverte par la masse de résine.

Selon encore une autre caractéristique avantageuse de l'invention, les extrémités des dents sont, à 20% près, à une même distance des extrémités des dents les plus proches. Cela contribue à faciliter le choix, pour un quelconque format de microcircuit donné, d'une extrémité de dent de peigne à laquelle connecter une borne appropriée de ce microcircuit, au moyen d'un fil raisonnablement court.

Selon encore une autre caractéristique avantageuse de l'invention, le module comporte deux peignes munis de quatre dents délimitant conjointement une zone centrale octogonale. Elle est de préférence régulière ; ce qui contribue à faciliter le choix, pour un quelconque format de microcircuit donné, d'une extrémité de dent de peigne à laquelle connecter une borne appropriée de ce microcircuit, au moyen d'un fil raisonnablement court.

Selon encore une autre caractéristique avantageuse de l'invention, il y a, entre les deux séries de trois plages de contact (C1-C3, C5-C7), deux plages transversales de contact (C4, C8) respectivement situées entre les premières plages de contact des deux séries, et entre les troisièmes plages de contact des deux séries, à distance d'une zone centrale située en regard du microcircuit et de la masse de résine d'enrobage., ce qui contribue à permettre un usage aussi complet des diverses bornes de connexion du microcircuit.

Selon encore une autre caractéristique avantageuse de l'invention, la face externe comporte en outre une plage centrale (C5A) connectée électriquement à l'une des plages de l'une des séries de plages de contact et séparée des deux plages transversales de contact par des fentes qui longent la périphérie de la masse de résine qui, sur l'autre face, enrobe le microcircuit. Cela contribue à rigidifier le film-support en regard de l'emplacement où le microcircuit est monté.

Selon encore une autre caractéristique avantageuse de l'invention, les fentes longeant les plages transversales de contact ont leur concavité tournée vers la zone centrale et la périphérie de ladite masse de résine a de même sa concavité tournée vers le microcircuit. Cela contribue à permettre une superposition au moins approximative de la périphérie de ladite masse et des fentes.

Selon une autre caractéristique avantageuse de l'invention, les vias sont connectés, sur la face interne, à des pistes métallisées ayant, à l'extérieur de la masse de résine une courbure égale à celle de portions élémentaires formant des fentes longeant les séries de plages de contact et une plage métallisée centrale. Cela contribue à la tenue mécanique du module.

Selon encore une autre caractéristique avantageuse de l'invention, les vias sont au nombre d'au moins 5.

Selon encore une autre caractéristique avantageuse de l'invention, les dimensions du module sont au plus celles du format M3 c'est-à-dire 11+/-0.2 mm*8,2+/-0.2 mm.

Selon un autre aspect de l'invention, celle-ci propose un film-support destiné à la fabrication de modules du type précité.

Elle propose à cet effet un film-support destiné à la fabrication d'un module du type précité, portant sur une face dite externe une pluralité de plages de contact électrique (C1-C8) et, sur une face dite interne, des zones internes de connexion et un emplacement destiné à recevoir un microcircuit comportant des bornes de direction devant être connectées à des plages du film-support par des fils, ce film-support étant traversé par des vias situés à distance de l'emplacement destiné au microcircuit, cette face interne étant destinée à être recouverte, conjointement avec le microcircuit par une masse de résine d'enrobage s'étendant jusqu'à une ligne donnée, caractérisé en ce que les plages de contact de la face externe comportent deux séries de trois plages seulement (C1-C3, C5-C7) s'étendant selon une direction donnée et en ce que les zones internes de connexion sont conformées en deux peignes dont les deux corps s'étendent respectivement sous chacune des deux séries de plage de contact, chaque corps s'étendant sous chacune des plages de la série correspondante à distance de la zone destinée à être recouverte par la masse d'enrobage, ces peignes ayant des dents qui s'étendent à partir de leurs corps transversalement à la direction donnée jusqu'à des extrémités aboutissant dans la zone destinée à être couverte par la masse d'enrobage.

Selon encore un autre aspect de l'invention, celle-ci propose une carte duale comportant un module du type précité.

Elle propose ainsi une carte à microcircuit duale comportant un corps de carte dans lequel est située une antenne et une cavité comportant une portion profonde entourée par une marche de moindre profondeur, ainsi qu'un module du type précité, l'antenne ayant des extrémités situées sur la marche entourant la portion profonde de la cavité, sur des côtés perpendiculaires à la direction suivant laquelle la carte est destinée à être insérée dans un terminal de lecture par contact, le microcircuit et sa masse de résine d'enrobage étant situés dans la portion profonde de la cavité, et le module étant fixé au corps de carte par une masse de résine reliant la périphérie du module tout au long de la marche, les zones internes de connexion étant en regard des extrémités de l'antenne, et la résine étant anisotropiquement électriquement conductrice perpendiculairement au plan du film-support.

Une carte à microcircuit conforme à l'invention comporte avantageusement les caractéristiques mentionnées ci-dessus à propos du module pris isolément. De manière particulièrement avantageuse, l'espace entre la masse de résine d'enrobage du microcircuit et la masse de résine anisotrope de fixation étant en regard de fentes délimitant des plages transversales de contact du module (C4, C8), entre les premières plages et les troisièmes plages desdites séries de plages de contact, et une plage centrale en regard de la totalité du microcircuit.

Des objets, caractéristiques et avantages de l'invention ressortent de la description qui suit, donnée à titre d'exemple illustratif non limitatif, en regard des dessins annexés sur lesquels :
- La figure 1 est une vue schématique éclatée d'une carte à microcircuit dont le microcircuit fait partie d'un module conforme à l'invention, monté dans une cavité du corps de la carte,
- La figure 2 est une vue partielle en coupe selon la ligne II-II de la figure 1 montrant le film-support du module et son microcircuit dans la cavité du corps,
- La figure 3 représente le dessin d'une pluralité de plages de contact portée par la face externe du film-support du module,
- La figure 4 représente le dessin d'un circuit imprimé porté par la face interne du film-support du module,
- La figure 5 est une vue montrant, par transparence au travers du film-support, la superposition des plages de la figure 3 et du circuit imprimé de la figure 4,
- La figure 6 est une vue montrant, par transparence au travers du film-support, non seulement la superposition des zones des figures 3 et 4 mais aussi des zones de résine avec lesquelles coopère le module lorsqu'il est monté dans la cavité d'un corps de carte.

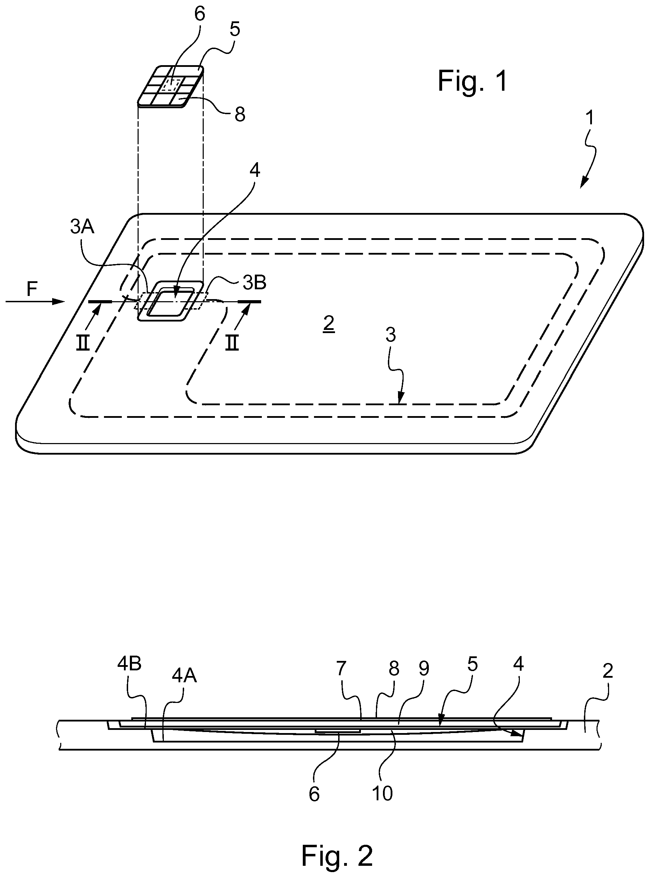

La figure 1 représente, de manière schématique et en vue éclatée, une carte à microcircuit 1, par exemple au format ID-1 ou 1FF (carte de crédit) comportant un corps 2 dans lequel une antenne 3 a été formée et qui comporte une cavité 4 dans laquelle est logé un module 5 comportant un microcircuit 6.

La cavité comporte une partie centrale 4A bordée le long de sa périphérie par une marche 4B de profondeur inférieure à celle de la partie centrale. L'antenne 3 comporte un nombre quelconque des spires, et deux extrémités élargies 3A et 3B situées sur la marche 4B. Le corps est en une ou plusieurs matières plastiques appropriées, connues en soi.

On voit à la figure 1 que, dans l'exemple représenté, les extrémités sont situées le long de côtés de la cavité qui sont perpendiculaires à la direction F suivant laquelle la carte est destinée à être insérée dans un lecteur de communication par contact (non représenté).

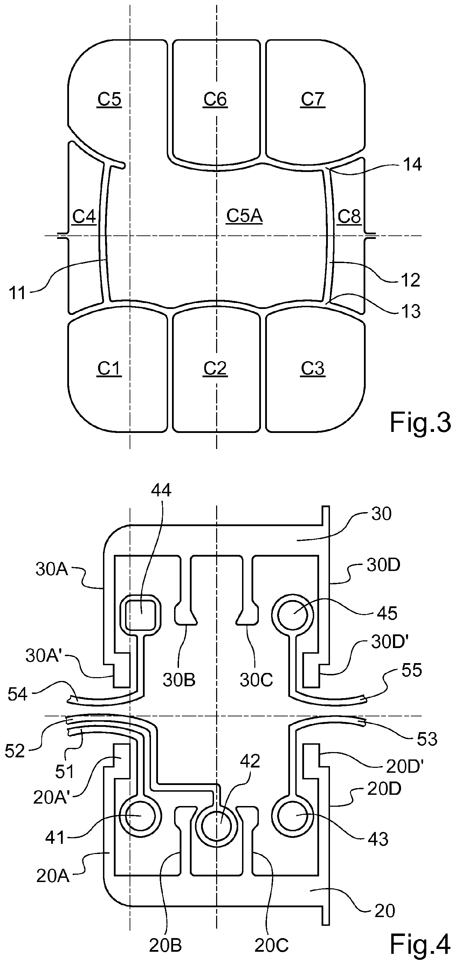

Le module 5 comporte un film-support 7 dont une face, dite face externe (ici la face supérieure, destinée à être orientée vers l'extérieur de la carte), porte une pluralité de plages de contact métalliques désignée conjointement par la référence 8 (sa configuration exacte n'est représentée que plus loin, notamment par la figure 3) et dont l'autre face, dite face interne (ici la face inférieure, destinée à être orientée vers le fond de la cavité) porte un circuit imprimé désigné dans son ensemble par la référence 9 ainsi que le microcircuit 6 (celui-ci est donc, à la figure 1, vu en transparence à travers le film-support).

Ce microcircuit est monté en sorte que ses bornes de connexion sont tournées vers le fond de la cavité (à l'opposé du film-support), de manière à permettre une connexion (ou câblage) par fil ; il ne s'agit donc pas d'un microcircuit monté à l'envers (montage connu sous la mention « flip-chip » où les bornes sont en regard de la face interne du film support).

Un avantage d'un tel montage par fil est que la géométrie du circuit imprimé peut être définie indépendamment du microcircuit qui lui est finalement associé ; mais cela a pour conséquence que les zones auxquelles les fils de connexion fixés aux bornes de connexion du microcircuit doivent être à l'écart de la zone couverte par le microcircuit (ces fils ne sont pas représentés sur ces figures 1 et 2). En ce qui concerne la connexion de certaines des bornes du microcircuit à des plages de contact situées sur la face externe, elle est faite au moyen de vias (non représentés sur ces figures 1 et 2), c'est-à-dire de trous traversant l'épaisseur du film-support. Les fils sont connectés sur le fond du via.

Dans le cas où la paroi interne des vias est reliée électriquement auxdites plages de contact, les fils de connexion peuvent être simplement soudés à l'intérieur de ces vias.

De manière classique, le microcircuit et les fils de connexion sont noyés dans une masse de résine rigide 10, dont la rigidité garantit une protection du microcircuit vis-à-vis de certains efforts mécaniques, tout en étant compatible avec une destruction du microcircuit en cas de tentative de détachement du microcircuit vis-à-vis du film-support.

La fixation du module à l'intérieur de la cavité non représentée) est effectuée au moyen d'une résine, ou un adhésif, électriquement conductrice (en pratique anisotrope) couvrant la marche 4B et/ou d'une autre résine interposée entre la résine de protection 10 et le fond de la cavité.

La figure 3 représente la face externe du module, avec diverses plages de contact, habituellement disposées en deux séries d'au moins trois plages, ici notées C1 à C3, C5 à C7, en conformité avec la notation normalisée (ces plages couvrent donc les zones minimales définies par ces normes) ; l'une, ici la plage C5, se prolonge vers le centre en une zone C5A ; on observe la présence de deux autres plages notées C4 et C8 qui peuvent, en conformité avec les normes, n'avoir aucun rôle. Ces plages, étant disposées en travers de l'espace séparant les deux séries de plages de contact sont appelés plages transversales de contact.

Les plages de contact sont ici séparées les unes des autres par des lignes de gravure ou fentes dépourvues de métal sur le film support.

Deux fentes 11 et 12 sont disposées entre la partie centrale C5A, d'une part, et chacune des zones C4 et C8. Ces fentes s'étendent ici depuis la fente 13 qui sépare cette partie centrale C5A des plages C1 à C3, d'une part, jusqu'à la fente 14 qui sépare cette partie centrale des plages C5 à C7 (cette fente est ici représentée discontinue pour permettre la continuité entre la plage C5 et la partie centrale C5A ; la partie séparant les plages C5 et C4 se prolonge sur une courte distance à l'intérieur de la liaison entre la plage C5 et la partie centrale C5A, ce qui constitue une amorce de rupture, si nécessaire, à l'endroit où s'interrompt la fente annulaire (en boucle) constituée conjointement par les fentes 11 à 14). Selon une variante non représentée, les plages C5 et C5a sont séparées.

Les vias mentionnés ci-dessus ne traversent pas ces plages de contact ; ces vias sont en effet obturés par les plages de contact en regard desquelles ils sont situés.

On peut noter que la plage C5A définit pour le film-support une zone centrale dont la rigidité est homogène. Elle est avantageusement en regard de la totalité du microcircuit et d'au moins une partie de la masse d'enrobage.

La figure 4 représente la face interne du module, plus exactement la face interne du film-support.

Le circuit imprimé désigné à la figure 2 sous la référence générale 9 comporte deux larges zones de contact 20 et 30 destinées à venir en contact avec les zones d'extrémité 3A et 3B de l'antenne ; ces larges zones, ont chacune une forme générale de peigne, ici à quatre dents ; en variante non représentée, il pourrait n'y avoir que deux dents, voire trois ; en fait le nombre de dents permet d'augmenter la facilité de connexion entre ces zones 20 et 30 avec les bornes correspondantes d'une grande variété de géométries de microcircuit. Ces peignes ont des corps (c'est-à-dire des parties à partir desquelles s'étendent les dents) qui s'étendent parallèlement aux séries de plages de contact, le corps du peigne 20 s'étendant sous chacune des plages C1 à C3 et le corps du peigne 30 s'étendant sous chacune des plages C5 à C7. Ces corps de peigne sont situés à proximité immédiate des bords du film-support qui sont parallèles aux séries de plages de contact (ils sont destinés à ne pas être couverts par la masse d'enrobage et être en regard du rebord de la cavité).

Ces peignes comportent au moins deux dents extrêmes partant des extrémités de leurs corps respectifs et de préférence au moins une dent intermédiaire ; chacune des dents s'étend, à partir du corps, indépendamment des autres, transversalement à la direction des séries de plages de contact (au moins approximativement perpendiculaire à cette direction, par exemple à 10° près).

Ces peignes sont ici symétriques l'un de l'autre par rapport à une ligne horizontale à la figure 4. En variante, non représentée, ces peignes peuvent avoir des nombres de dents différents (par exemple 4 pour le peigne 20 et 3 pour le peigne 30 ; en fait, ainsi que cela ressort de la suite, le nombre de dents peut dépendre du nombre de vias.

De manière avantageuse, les dents extrêmes, 20A et 20D, d'une part, et 30A et 30D, d'autre part, sont plus longues que les dents intermédiaires 20B et 20C, 30B et 30C. ; en outre, les extrémités de ces dents extrêmes présentent de préférence des décrochements 20A', 20D', 30A' et 30D' vers le centre de la face interne du film-support. Les extrémités des dents sont ici localement élargies.

Le circuit imprimé 9 de la figure 4 comporte en outre, ici, des zones annulaires, ou collerettes, entourant les vias nécessaires à la connexion des bornes de connexion du microcircuit aux plages appropriées de la face externe. Ces collerettes empêchent le dépôt de résidus ou de poussière sur le bord du via.

Ces vias sont ici au nombre de 5, à savoir trois vias 41, 42 et 43 entre les quatre dents du peigne 20 et deux vias 44 et 45 entre les dents 30A et 30B, et les dents 30C et 30D du peigne 30.

Ces zones annulaires, dont la superficie peut être aussi faible qu'on peut le souhaiter, sont ici reliées à des pistes conductrices notées 51 à 55. Ces pistes n'ont, en service, pas de rôle particulier, puisque leur principale fonction est d'amener du courant à l'emplacement des vias pour, lors de la fabrication du film-support, assurer une bonne métallisation des zones annulaires et éventuellement de leur paroi interne. Toutefois, ainsi que cela sera commenté plus loin, ces pistes sont en pratique conservées en raison du rôle de rigidification, ou au contraire du rôle de guidage en déformation qu'elles peuvent jouer.

Les vias sont représentés comme ayant une section circulaire (vias 41-43 et 45) ou carrée avec des coins arrondis (via 44) ; les zones annulaires qui les entourent ont en pratique une même forme circulaire ou carrée. On comprend toutefois que les vias peuvent avoir une section quelconque.

Les dents des peignes 20 et 30 ainsi que les vias laissent subsister une zone centrale non métallisée, en regard de la zone C5A de la face externe, destinée à recevoir le microcircuit 6. Comme indiqué ci-dessus, la géométrie du circuit imprimé 9 permet de s'adapter à une grande variété de microcircuits, ce qui signifie que la production du film-support avec la métallisation de ses faces internes et externes peut être effectuée d'une manière unique, indépendamment de la nature du microcircuit qui leur sera finalement fixé ; on comprend que cela contribue à maintenir à un faible niveau le coût du film-support.

Plus précisément, on peut noter que les dents extrêmes définissent par leurs extrémités un polygone, plus précisément un octogone dans l'exemple représenté, puisqu'il y deux peignes à quatre dents. Ce polygone a avantageusement des côtés qui sont au moins approximativement égaux (par exemple à 20% près). On peut noter que les vias sont ici à l'extérieur de ce polygone. En fait, l'essentiel de la surface de ce polygone est disponible pour l'implantation du microcircuit, à l'exception des pistes métallisées qui longent de préférence la périphérie de ce polygone (plus précisément, les pistes sont ici formées de brins soit perpendiculaires, soit parallèles, à la direction des séries de plages de contact. On peut également noter que, dans l'exemple représenté, la distance entre les extrémités de dents extrêmes en regard des peignes, par exemple la distance entre les extrémités 20A' et 30A', est au plus égale à la longueur des dents intermédiaire.

En effet, les extrémités des dents extrêmes définissent des passages étroits pour que les pistes métallisées puissent sortir du polygone précité ; plus précisément, c'est en des zones médianes, sensiblement équidistantes des corps de peignes que les pistes sortent de ce polygone, en ayant une forme courbe.

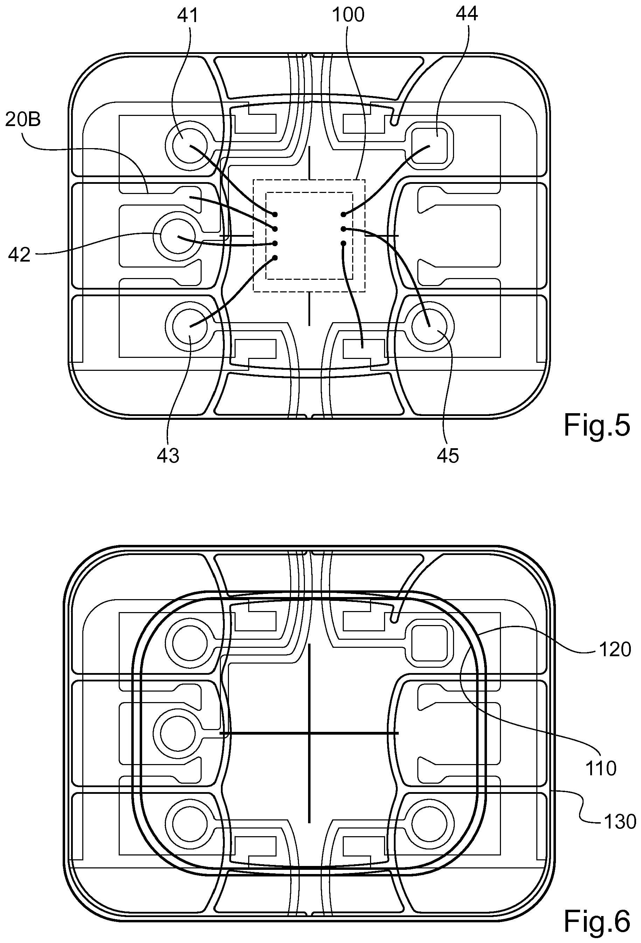

La figure 5 représente le module en vue de dessus, montrant toutefois, par transparence au travers du film-support, ce qui est situé sous ce film-support.

On observe ainsi que le peigne 20 est situé sous les plages C1 à C3 tandis que le peigne 30 est situé sous les plages C5 à C7. En outre, les vias 41 à 43 sont respectivement situés sous les plages C1 à C3, tandis que les vias 44 et 45 sont respectivement situés sous les plages C5 et C7. Les extrémités des dents extrêmes sont suffisamment allongées pour que leurs extrémités ne soient pas en regard des plages sous lesquelles s'étendent leurs corps respectifs ; plus précisément, ces extrémités sont ici situées entre ces séries, sous la zone centrale, ce qui est favorable à la tenue mécanique du module

Un cadre en pointillé 100 représente l'espace disponible pour implanter un microcircuit et, à l'intérieur de ce cadre virtuel, un cadre en tirets délimite un exemple de microcircuit. On peut noter que, sur ce microcircuit, il y a 4 bornes à gauche et 3 bornes à droite ; les quatre bornes à gauche sont respectivement connectées aux vias 41 à 43 et à la dent 20B du peigne 20 tandis que les trois bornes de droite sont respectivement connectées aux vias 44 et 45 et à la dent 30D du peigne 30. On comprend aisément que, avec un microcircuit dont les bornes de connexion ont une autre configuration, il peut être approprié de connecter des bornes à l'une quelconque des dents du peigne 20 et à l'une quelconque des dents du peigne 30.

On peut noter que le microcircuit, dès lors qu'il se trouve dans le cadre virtuel 100, se trouve en regard d'une zone rigidifiée du film-support (en raison de la zone C5A) qui est en outre rigidifiée par les lignes de courant 51 à 55 dont la présence tendent à rigidifier la zone centrale à la manière d'un cadre qui rigidifie une toile.

La figure 6 représente, par analogie avec la figure 5, le module en vue de dessus, montrant toutefois, par transparence au travers du film-support, ce qui est situé sous ce film-support.

On observe ainsi, comme sur la figure 5, le peigne 20 est situé sous les plages C1 à C3 tandis que le peigne 30 est situé sous les plages C5 à C7. En outre, les vias 41 à 43 sont respectivement situés sous les plages C1 à C3, tandis que les vias 44 et 45 sont respectivement situés sous les plages C5 et C7.

A la différence de la figure 5, la figure 6 ne visualise pas de microcircuit ; toutefois, on observe une ligne courbe 110 longée par une ligne courbe 120, puis, près du bord du film-support, une autre ligne courbe 130.

La ligne 110 représente la périphérie de la masse de résine d'enrobage du microcircuit. Elle englobe une fraction importante de la superficie totale du film-support ; en particulier, elle entoure non seulement la zone centrale recevant le microcircuit (non représenté), mais aussi les vias 41 à 45 et les extrémités des dents des peignes 20 et 30. Ainsi cette ligne 110 enrobe nécessairement les fils de connexion entre les bornes de connexion du microcircuit et les peignes ainsi que les vias. Par contre, cette ligne 110 n'englobe pas les corps des peignes 20 et 30 ; dans l'exemple représenté, elle n'englobe pas non plus le début des dents (elle ne recouvre de préférence pas plus de 75% de la longueur des dents).

Il est à noter que, pour permettre une bonne connexion du microcircuit aux vias et aux dents du peigne, ces vias et ces extrémités doivent être situées à l'écart de la zone de réception du microcircuit (ligne 100), mais à l'intérieur de la ligne 110. Le fait que les dents extrêmes des peignes soient plus longues que les dents intermédiaires a pour avantage qu'il existe des extrémités de dents en regard de chacun des côtés du microcircuit ; et le fait que les extrémités des dents extrêmes comportent un décrochement vers la zone centrale contribue à garantir que, même avec des tolérances significatives dans le respect de la ligne 110 par la masse de résine d'enrobage effectivement déposée, ces extrémités sont bien recouvertes par cette masse.

On peut noter que la masse de résine d'enrobage s'étend sur une zone rectangulaire (aux coins arrondis) à peine plus grande que le polygone défini par l'ensemble des vias.

A la différence de qui est représenté à la figure 2, la masse de présente une forme approximativement parallélépipédique.*

On peut noter que le microcircuit recouvre une partie entièrement dénuée de métal du film-support, ce qui contribue à assurer une bonne fixation du microcircuit, d'une part en raison de la planéité de cette partie recouverte, et d'autre part en raison de ce que l'adhésion au film-support est meilleure que l'adhésion au métal conducteur, du cuivre en pratique.

La ligne 120 définit le bord interne de la marche 4B entourant la partie centrale profonde de la cavité tandis que la ligne 130 en délimite le bord externe ; la zone située entre les lignes 120 et 130 correspond donc à la zone encollée de résine pour la fixation du module sur la marche de la cavité.

On peut noter que l'espace entre les lignes 110 et 120 délimite ainsi l'espace entre la masse de résine d'enrobage et la masse de résine de fixation à la marche 4B. Cet espace ne représente qu'une très faible fraction de la superficie du module, typiquement inférieure à 10%, voire moins de 5%. Cela signifie que le module est rigidifié, par la combinaison des deux masses de résine, sur la quasi-totalité de sa superficie.

Toutefois, selon une caractéristique intéressante de l'invention, la bande délimitée entre les lignes 110 et 120 se superpose avantageusement avec les fentes 11 et 12 délimitant les plages C4 et C8, respectivement, vis-à-vis de la zone centrale C5A. cette superposition est facilité lorsque, comme cela est représenté à titre d'exemple, les fentes 11 et 12 sont convexes. Il en découle, en combinaison avec la rigidification précitée, une capacité à fléchir en ces endroits qui sont perpendiculaires aux séries de plages de contact C1-C3, C5-C7 ; il est surtout intéressant de noter que cette capacité à fléchir est située en regard de l'espace situé entre la masse de résine d'enrobage et la paroi de la zone centrale de la cavité. Cette zone de flexibilité du module en tant que tel se situe donc à l'emplacement d'une zone de flexibilité de la carte munie de ce module

Diverses variantes rentrent dans le cadre de l'invention, notamment le fait que le nombre de vias au travers du film-support, ici de 5, peut être plus faible (par exemple 4).

Il est à noter que, malgré la petite taille du film-support, le microcircuit est efficacement enrobé, en même temps que les fils de connexion aux peignes et aux vias (le taux de remplissage de la cavité par la résine d'enrobage est important), tout en laissant une superficie significative pour la fixation sur la marche bordant la cavité, et tout en respectant un niveau significatif de flexibilité. On obtient une bonne adhésion entre le module et le corps de carte. Ces avantages sont renforcés par le fait que les dents extrêmes ont des extrémités présentant des décrochements vers la zone centrale. Les extrémités sont donc disposées dans la zone centrale laissant une surface significative pour la fixation des bords perpendiculaires aux séries de plages de contacts.

Une telle configuration est apparue respecter les tests normalisés en flexion et en torsion.

En effet la présence de la zone centrale C5A favorise la rigidification de la partie centrale du module, mais on comprend que la résine d'enrobage apporte déjà en soi un niveau significatif de rigidité au module, notamment en sa portion centrale.

Quant à la fente presque continue formée par les fentes 11 à 14, elle a l'avantage de permettre une flexion/torsion à distance du microcircuit, compatible avec un retour à la configuration plane après les sollicitations.

Ces fentes permettent en outre un relâchement des contraintes selon diverses directions possibles.

Le fait que les fentes 13 et 14 séparant les séries de plages C1-C3 et C5-C7 vis-à-vis de la zone centrale sont formée de fentes élémentaires ayant la même courbure que les pistes d'alimentation 51 à 54 parallèlement à ces fentes 13 et 14 a l'avantage de mettre en oeuvre des lignes d'attaque de même rayon, ce qui facilite la fabrication. Quant à l'existence même des lignes d'alimentation, leur orientation approximativement parallèlement aux fentes 13 et 14 a pour avantage de définir des lignes de faiblesse ou de rigidité qui sont parallèles, ce qui est favorable à un guidage des déformations suivant ces lignes. En particulier, les lignes d'alimentation assurent un guidage d'un éventuel relâchement des contraintes au sein de la zone de fixation du module à la marche bordant la cavité.

Le fait que ces fentes élémentaires ont leur concavité tournée vers l'extérieur du module alors que les fentes 11 et 12 ont leur concavité tournée vers le centre du module a l'avantage de réduire le risque d'une cassure à ces endroits qui ne sont pas rectilignes.

Dans l'exemple représenté, le module est au format M3.

## Revendications

1. Module dual pour carte duale à microcircuit, comportant un film-support (7) portant sur une face dite externe une pluralité de plages de contact électrique (C1-C8) comportant deux séries de plages de contact électrique s'étendant selon une direction donnée en longeant sur toute leur longueur deux bords de ce film-support qui sont parallèles à cette direction et, sur une face dite interne deux zones internes de connexion (9) destinées à être connectées à une antenne de ladite carte duale à microcircuit et un microcircuit (6), ce microcircuit comportant des bornes de connexion connectées par des fils respectivement aux zones internes de connexion ou à certaines des plages de contact électrique par l'intermédiaire de vias (41-45) traversant ce film-support tout en étant enrobé, conjointement avec ces fils, par une masse de résine d'enrobage, **caractérisé en ce que** les séries de plages de contact électrique de la face externe comportent trois plages seulement (C1-C3, C5-C7) et **en ce que** chacune des deux zones internes de connexion est conformée en un peigne (20, 30) comportant un corps s'étendant sous chacune des plages de l'une respective des deux séries de plage de contact à distance de la masse d'enrobage, et des dents, dont deux dents extrêmes partant des extrémités du corps et au moins une dent intermédiaire (20A-D, 30A-D), qui s'étendent indépendamment les unes des autres à partir dudit corps transversalement à la direction donnée jusqu'à des extrémités couvertes par la masse d'enrobage, l'une des extrémités d'une dent de chaque peigne étant connectée par un desdits fils à une desdites bornes de connexion du microcircuit.

2. Module dual selon la revendication 1, dont les dents des peignes s'étendent à partir de leur corps de part et d'autre des vias, les dents extrêmes de chaque peigne, qui sont les plus éloignées l'une de l'autre, étant plus longues que les autres dents du même peigne de sorte que leurs extrémités sont en regard d'une zone de la face externe qui est située entre lesdites séries de plages de contact électrique.

3. Module dual selon la revendication 2 dont les vias sont reliés, sur la face interne du film-support, à des pistes métallisées parallèles et/ou perpendiculaires à la direction des séries de plages, passant entre les extrémités, en regard, des dents extrêmes de deux peignes distincts, en des zones médianes sensiblement situées à mi-distance des bords du film-support qui sont longées par les séries de plages de contact électrique.

4. Module dual selon la revendication 3, dont les pistes métallisées reliées aux vias ont, à l'extérieur de la masse de résine enrobant le microcircuit et les fils de connexion, une forme courbe.

5. Module dual selon l'une quelconque des revendications 2 à 4, dont les extrémités des dents des deux peignes délimitent conjointement une zone centrale polygonale entourant le microcircuit, à l'extérieur de laquelle sont situés les vias.

6. Module dual selon l'une quelconque des revendications 2 à 5, dont les dents extrêmes ont des extrémités présentant des décrochements vers la zone centrale.

7. Module dual selon l'une quelconque des revendications 2 à 6, comportant deux peignes munis de quatre dents délimitant conjointement une zone centrale octogonale.

8. Module dual selon l'une quelconque des revendications 1 à 7, comportant, entre les deux séries de trois plages de contact (C1-C3, C5-C7), deux plages transversales de contact (C4, C8) respectivement situées entre les premières plages de contact des deux séries, et entre les troisièmes plages de contact des deux séries, à distance d'une zone centrale située en regard du microcircuit et de la masse de résine d'enrobage.

9. Module dual selon la revendication 8, dont la face externe comporte en outre une plage centrale (C5A) connectée électriquement à l'une des plages de l'une des séries de plages de contact et séparée des deux plages transversales de contact par des fentes (11, 12) qui longent la périphérie de la masse de résine qui, sur l'autre face, enrobe le microcircuit.

10. Module dual selon la revendication 9, dont les fentes longeant les plages transversales de contact ont leur concavité tournée vers la zone centrale et dont la périphérie de ladite masse de résine a de même sa concavité tournée vers le microcircuit.

11. Module dual selon l'une quelconque des revendications 1 à 10, dont les vias sont connectés, sur la face interne, à des pistes métallisées ayant, à l'extérieur de la masse de résine une courbure égale à celle de portions élémentaires formant des fentes (13, 14) longeant les séries de plages de contact et une plage métallisée centrale.

12. Module dual selon l'une quelconque des revendications 1 à 11, dont les dimensions sont au plus celles du format M3 c'est-à-dire 11+/- 0.2mm*8,2+/-0.2mm.

13. Film-support destiné à la fabrication d'un module selon l'une quelconque des revendications 1 à 12, portant sur une face dite externe une pluralité de plages de contact électrique (C1-C8) et, sur une face dite interne, des zones internes de connexion (9) et un emplacement (100) destiné à recevoir un microcircuit comportant des bornes de direction devant être connectées à des plages du film-support par des fils, ce film-support étant traversé par des vias (41-45) situés à distance de l'emplacement destiné au microcircuit, cette face interne étant destinée à être recouverte, conjointement avec le microcircuit par une masse de résine d'enrobage s'étendant jusqu'à une ligne donnée (110), **caractérisé en ce que** les plages de contact de la face externe comportent deux séries de trois plages seulement (C1-C3, C5-C7) s'étendant selon une direction donnée et **en ce que** les zones internes de connexion sont conformées en deux peignes (20, 30) dont les deux corps s'étendent respectivement sous chacune des deux séries de plage de contact, chaque corps s'étendant sous chacune des plages de la série correspondante à distance de la zone destinée à être recouverte par la masse d'enrobage, ces peignes ayant des dents (20A-D, 30A-D) qui s'étendent à partir de leurs corps transversalement à la direction donnée jusqu'à des extrémités aboutissant dans la zone destinée à être couverte par la masse d'enrobage.

14. Carte à microcircuit duale comportant un corps de carte dans lequel est située une antenne (6) et une cavité comportant une portion profonde entourée par une marche (4B) de moindre profondeur, ainsi qu'un module selon l'une quelconque des revendications 1 à 12, l'antenne ayant des extrémités (3A, 3B) situées sur la marche entourant la portion profonde de la cavité, sur des côtés perpendiculaires à la direction (F) suivant laquelle la carte est destinée à être insérée dans un terminal de lecture par contact, le microcircuit et sa masse de résine d'enrobage étant situés dans la portion profonde de la cavité, et le module étant fixé au corps de carte par une masse de résine reliant la périphérie du module tout au long de la marche, les zones internes de connexion étant en regard des extrémités de l'antenne, et la résine étant anisotropiquement électriquement conductrice perpendiculairement au plan du film-support.

15. Carte duale selon la revendication 14, dans lequel l'espace entre la masse de résine d'enrobage du microcircuit et la masse de résine anisotrope de fixation étant en regard de fentes (11, 12) délimitant des plages transversales de contact du module (C4, C8), entre les premières plages et les troisièmes plages desdites séries de plages de contact, et une plage centrale (C5A) en regard de la totalité du microcircuit.

## Patentansprüche

1. Duales Modul für eine duale Mikroschaltungskarte, das eine Trägerfolie (7) aufweist, die auf einer so genannten Außenseite eine Vielzahl von elektrischen Kontaktbereichen (C1-C8), die zwei Reihen von elektrischen Kontaktbereichen aufweist, die sich gemäß einer gegebenen Richtung erstrecken, indem sie über ihre ganze Länge entlang von zwei Rändern dieser Trägerfolie verlaufen, die parallel zu dieser Richtung sind, und auf einer so genannten Innenseite zwei innere Verbindungszonen (9), die dazu bestimmt sind, mit einer Antenne der dualen Mikroschaltungskarte verbunden zu werden, und eine Mikroschaltung (6) trägt, wobei diese Mikroschaltung Anschlussklemmen aufweist, die durch Drähte je mit den inneren Verbindungszonen oder mit bestimmten der elektrischen Kontaktbereiche mittels Lücken (41-45) verbunden sind, die diese Trägerfolie durchqueren, während sie zusammen mit diesen Drähten von einer Umhüllungsharzmasse umhüllt ist, **dadurch gekennzeichnet, dass** die Reihen von elektrischen Kontaktbereichen der Außenseite nur drei Bereiche (C1-C3, C5-C7) aufweisen, und dass jede der zwei inneren Verbindungszonen als ein Kamm (20, 30) gestaltet ist, der einen Körper, der sich unter jedem der Bereiche einer der zwei Reihen von Kontaktbereichen in Abstand zur Umhüllungsmasse erstreckt, und Zähne aufweist, darunter zwei Endzähne, die von den Enden des Körpers ausgehen, und mindestens ein Zwischenzahn (20A-D, 30A-D), die sich unabhängig voneinander ausgehend vom Körper quer zur gegebenen Richtung bis zu von der Umhüllungsmasse bedeckten Enden erstrecken, wobei eines der Enden eines Zahns jedes Kamms durch einen der Drähte mit einer der Anschlussklemmen der Mikroschaltung verbunden ist.

2. Duales Modul nach Anspruch 1, bei dem die Zähne der Kämme sich ausgehend von ihrem Körper zu beiden Seiten der Lücken erstrecken, wobei die Endzähne jedes Kamms, die am weitesten voneinander entfernt sind, länger sind als die anderen Zähne des gleichen Kamms, so dass ihre Enden sich gegenüber einer Zone der Außenseite befinden, die sich zwischen den Reihen von elektrischen Kontaktbereichen befindet.

3. Duales Modul nach Anspruch 2, bei dem die Lücken auf der Innenseite der Trägerfolie mit metallisierten Streifen parallel und/oder lotrecht zur Richtung der Reihen von Bereichen verbunden sind, die zwischen den gegenüberliegenden Enden der Endzähne von zwei unterschiedlichen Kämmen in Mittelzonen durchgehen, die sich im Wesentlichen in halbem Abstand zu den Rändern der Trägerfolie befinden, an denen die Reihen von elektrischen Kontaktbereichen längs verlaufen.

4. Duales Modul nach Anspruch 3, bei dem die mit den Lücken verbundenen metallisierten Streifen außerhalb der die Mikroschaltung und die Verbindungsdrähte umhüllenden Harzmasse eine gekrümmte Form haben.

5. Duales Modul nach einem der Ansprüche 2 bis 4, bei dem die Enden der Zähne der zwei Kämme zusammen eine die Mikroschaltung umgebende polygonale zentrale Zone begrenzen, außerhalb der sich die Lücken befinden.

6. Duales Modul nach einem der Ansprüche 2 bis 5, bei dem die Endzähne Enden haben, die Rücksprünge zur zentralen Zone aufweisen.

7. Duales Modul nach einem der Ansprüche 2 bis 6, das zwei Kämme aufweist, die mit vier Zähnen versehen sind, die zusammen eine achteckige zentrale Zone begrenzen.

8. Duales Modul nach einem der Ansprüche 1 bis 7, das zwischen den zwei Reihen von drei Kontaktbereichen (C1-C3, C5-C7) zwei Querkontaktbereiche (C4, C8) aufweist, die sich zwischen den ersten Kontaktbereichen der zwei Reihen bzw. zwischen den dritten Kontaktbereichen befinden, in Abstand zu einer zentralen Zone, die sich gegenüber der Mikroschaltung und der Umhüllungsharzmasse befindet.

9. Duales Modul nach Anspruch 8, bei dem die Außenseite außerdem einen zentralen Bereich (C5A) aufweist, der elektrisch mit einem der Bereiche einer der Reihen von Kontaktbereichen verbunden und von den zwei Querkontaktbereichen durch Schlitze (11, 12) getrennt ist, die entlang des Umfangs der Harzmasse verlaufen, die auf der anderen Seite die Mikroschaltung umhüllt.

10. Duales Modul nach Anspruch 9, bei dem die entlang der Querkontaktbereiche verlaufenden Schlitze ihre Konkavität zur zentralen Zone weisend haben und bei dem der Umfang der Harzmasse ebenfalls seine Konkavität zur Mikroschaltung weisend hat.

11. Duales Modul nach einem der Ansprüche 1 bis 10, bei dem die Lücken auf der Innenseite mit metallisierten Streifen verbunden sind, die außerhalb der Harzmasse eine Krümmung gleich derjenigen der Elementarabschnitte haben, die Schlitze (13, 14) bilden, die entlang der Reihen von Kontaktbereichen und eines zentralen metallisierten Bereichs verlaufen.

12. Duales Modul nach einem der Ansprüche 1 bis 11, bei dem die Abmessungen höchstens diejenigen des Formats M3 sind, d.h. 11+/-0,2mm*8,2+/-0,2mm.

13. Trägerfolie, die zur Herstellung eines Moduls nach einem der Ansprüche 1 bis 12 bestimmt ist, die auf einer so genannten Außenseite eine Vielzahl von elektrischen Kontaktbereichen (C1-C8) und auf einer so genannten Innenseite innere Verbindungszonen (9) und eine Stelle (100) trägt, die dazu bestimmt ist, eine Mikroschaltung aufzunehmen, die Richtungsklemmen aufweist, die mit Bereichen der Trägerfolie durch Drähte verbunden werden sollen, wobei diese Trägerfolie von Lücken (41-45) durchquert wird, die sich in Abstand zur für die Mikroschaltung bestimmten Stelle befinden, wobei diese Innenseite dazu bestimmt ist, zusammen mit der Mikroschaltung von einer Umhüllungsharzmasse bedeckt zu werden, die sich bis zu einer gegebenen Linie (110) erstreckt, **dadurch gekennzeichnet, dass** die Kontaktbereiche der Außenseite zwei Reihen von nur drei Bereichen (C1-C3, C5-C7) aufweisen, die sich gemäß einer gegebenen Richtung erstrecken, und dass die inneren Verbindungszonen als zwei Kämme (20, 30) gestaltet sind, deren zwei Körper sich je unter jeder der zwei Reihen von Kontaktbereichen erstrecken, wobei jeder Körper sich unter jedem der Bereiche der entsprechenden Reihe in Abstand zu der Zone erstreckt, die dazu bestimmt ist, von der Umhüllungsmasse bedeckt zu werden, wobei diese Kämme Zähne (20A-D, 30A-D) haben, die sich ausgehend von ihren Körpern quer zur gegebenen Richtung bis zu Enden erstrecken, die in der Zone enden, die dazu bestimmt ist, von der Umhüllungsmasse bedeckt zu werden.

14. Duale Mikroschaltungskarte, die einen Kartenkörper, in dem sich eine Antenne (6) und ein Hohlraum befinden, der einen tiefen Abschnitt umgeben von einer Stufe (4B) geringerer Tiefe aufweist, sowie ein Modul nach einem der Ansprüche 1 bis 12 aufweist, wobei die Antenne Enden (3A, 38) hat, die sich auf der den tiefen Abschnitt des Hohlraums umgebenden Stufe befinden, auf Seiten lotrecht zur Richtung (F), gemäß der die Karte in ein Kontakt-Leseterminal eingeführt werden soll, wobei die Mikroschaltung und ihre Umhüllungsharzmasse sich im tiefen Abschnitt des Hohlraums befinden, und das Modul am Kartenkörper durch eine Harzmasse befestigt ist, die den Umfang des Moduls entlang der ganzen Stufe verbindet, wobei die inneren Verbindungszonen sich gegenüber den Enden der Antenne befinden, und das Harz anisotropisch elektrisch leitend lotrecht zur Ebene der Trägerfolie ist.

15. Duale Karte nach Anspruch 14, wobei der Raum zwischen der Umhüllungsharzmasse der Mikroschaltung und der anisotropischen Befestigungsharzmasse sich gegenüber von Schlitzen (11, 12) befindet, die Querkontaktbereiche des Moduls (C4, C8) zwischen den ersten Bereichen und den dritten Bereichen der Reihen von Kontaktbereichen und einen zentralen Bereich (C5A) gegenüber der Gesamtheit der Mikroschaltung begrenzen.

## Claims

1. Dual module for a dual chip card, comprising a supporting film (7) supporting on an outer surface a plurality of electrical contact pads (C1-C8) including two series of electrical contact pads extending in a given direction for their entire length along two edges of this supporting film which are parallel to this direction and, on an inner surface, two internal connection zones (9) designed to be connected to an antenna of said dual chip card and a microcircuit (6), this microcircuit having connection terminals connected by wires respectively to the internal connection zones or to certain of the electrical contact pads by means of holes (41-45) passing through this supporting film while being coated, together with these wires, by a coating resin mass, **characterized in that** the series of electrical contact pads of the outer surface have only three pads (C1-C3, C5-C7) and **in that** each of the two internal connection zones is shaped as a comb (20, 30) comprising a body extending under each of the pads of one of the two series of contact pads separated from the coating mass, and teeth, including two end teeth starting at the ends of the body and at least one intermediate tooth (20A-D, 30A-D), which extend independently of one another from said body, transversely to the given direction, as far as the ends covered by the coating mass, one of the ends of one tooth of each comb being connected by one of said wires to one of said connection terminals of the microcircuit.

2. Dual module according to Claim 1, whose teeth of the combs extend from their body on either side of the holes, the outermost teeth of each comb, which are the ones furthest apart from each other, being longer than the other teeth of the same comb, so that their ends are next to a zone of the outer surface which is situated between said series of electrical contact pads.

3. Dual module according to Claim 2, whose holes are connected, on the inner surface of the supporting film, to metallized tracks parallel and/or perpendicular to the direction of the series of pads, passing between the opposite ends of the outermost teeth of two distinct combs, in middle zones substantially located midway from the edges of the supporting film, which are bordered by the series of electrical contact pads.

4. Dual module according to Claim 3, whose metallized tracks connected to the holes have a curved shape, on the outside of the resin mass coating the microcircuit and the connection wires.

5. Dual module according to any one of Claims 2 to 4, whose ends of the teeth of the two combs jointly delimit a polygonal central zone surrounding the microcircuit, on the outside of which are situated the holes.

6. Dual module according to any one of Claims 2 to 5, whose outermost teeth have ends with indentations toward the central zone.

7. Dual module according to any one of Claims 2 to 6, comprising two combs provided with four teeth jointly delimiting an octagonal central zone.

8. Dual module according to any one of Claims 1 to 7, comprising, between the two series of three contact pads (C1-C3, C5-C7), two transverse contact pads (C4, C8) respectively situated between the first contact pads of the two series and between the third contact pads of the two series, at a distance from a central zone situated next to the microcircuit and the coating resin mass.

9. Dual module according to Claim 8, whose outer surface furthermore has a central pad (C5A) electrically connected to one of the pads of one of the series of contact pads and separated from the two transverse contact pads by slots (11, 12) along the periphery of the resin mass coating the microcircuit on the other surface.

10. Dual module according to Claim 9, whose slots along the transverse contact pads have their concavity turned toward the central zone and whose periphery of said resin mass likewise has its concavity turned toward the microcircuit.

11. Dual module according to any one of Claims 1 to 10, whose holes are connected, on the inner surface, to metallized tracks having, on the outside of the resin mass, a curvature equal to that of elementary portions forming slots (13, 14) along the series of contact pads and a central metallized pad.

12. Dual module according to any one of Claims 1 to 11, whose dimensions are at most those of the format M3, that is, 11+/-0.2mm*8.2+/-0.2mm.

13. Supporting film intended for the fabrication of a module according to any one of Claims 1 to 12, supporting on an outer surface a plurality of electrical contact pads (C1-C8) and, on an inner surface, internal connection zones (9) and a location (100) designed to receive a microcircuit comprising direction terminals needing to be connected to pads of the supporting film by wires, this supporting film being traversed by holes (41-45) situated at a distance from the location designed for the microcircuit, this inner surface being adapted to be covered, together with the microcircuit, by a mass of coating resin extending as far as a given line (110), **characterized in that** the contact pads of the outer surface comprise two series of only three pads (C1-C3, C5-C7), extending in a given direction, and **in that** the internal connection zones are shaped as two combs (20, 30) whose two bodies extend respectively under each of the two series of contact pads, each body extending under each of the pads of the corresponding series at a distance from the zone which is to be covered by the coating mass, these combs having teeth (20A-D, 30A-D) which extend from their body, transversely to the given direction, as far as the ends emerging in the zone intended to be covered by the coating mass.

14. Dual chip card comprising a card body in which is situated an antenna (6) and a cavity comprising a deep portion surrounded by a course (4B) of lesser depth, as well as a module according to any one of Claims 1 to 12, the antenna having ends (3A, 3B) situated on the course surrounding the deep portion of the cavity, on sides perpendicular to the direction (F) in which the card is intended to be inserted into a card reading terminal, the microcircuit and its mass of coating resin being situated in the deep portion of the cavity, and the module being secured to the card body by a mass of resin connecting the periphery of the module all along the course, the internal connection zones being next to the ends of the antenna, and the resin being anisotropically electrically conductive perpendicular to the plane of the supporting film.

15. Dual card according to Claim 14, wherein the space between the mass of coating resin of the microcircuit and the mass of anisotropic attachment resin is next to slots (11, 12) delimiting transverse contact pads of the module (C4, C8), between the first pads and the third pads of said series of contact pads, and a central pad (C5A) next to the entire microcircuit.
